Europäisches Patentamt

European Patent Office

Office européen des brevets

(19)

(11) Publication number: **0 047 065**
**B1**

(12) **EUROPEAN PATENT SPECIFICATION**

(45) Date of publication of patent specification: **01.10.86**

(51) Int. Cl.⁴: **G 01 N 24/04**

(21) Application number: **81303522.7**

(22) Date of filing: **31.07.81**

(54) **Distributed phase RF coil.**

(30) Priority: **29.08.80 US 182525**

(43) Date of publication of application:
**10.03.82 Bulletin 82/10**

(45) Publication of the grant of the patent:
**01.10.86 Bulletin 86/40**

(84) Designated Contracting States:
**BE CH DE FR GB LI NL SE**

(56) References cited:
**DE-A-2 942 020**
**US-A-4 095 168**

(73) Proprietor: **TECHNICARE CORPORATION**
**29100 Aurora Road**
**Solon, Ohio 44139 (US)**

(72) Inventor: **Hinshaw, Waldo Stephen**
**Apt. 709 25300 Rockside Road**
**Bedford Heights Ohio 44146 (US)**
Inventor: **Gauss, Robert Charles**
**80 West Mennonite Road**
**Aurora Ohio 44202 (US)**

(74) Representative: **Colgan, Stephen James et al**
**CARPMALES & RANSFORD**
**43 Bloomsbury Square**
**London WC1A 2RA. (GB)**

## Description

Technical Field

This invention relates to nuclear magnetic resonance (NMR), and in particular, to RF coil designs particularly well suited for NMR imaging. The RF coil provides the dual function of a transmitting or exciting coil for applying an RF magnetic field to a sample under NMR analysis and of a receiving coil for detecting the radio frequency magnetization of the sample.

Background Art

In recent years, advances in the art of superconducting magnets have permitted NMR spectrometers to be built which operate at frequencies as high as 600 megahertz. At such frequencies, the performance of the RF coil in the spectrometer becomes a major limiting factor in the overall system performance. The RF coil, which surrounds the sample under analysis, has the function of magnetically coupling the spectrometer to the sample. An example of a prior art RF coil circuit for a nuclear magnetic resonance probe having a tuning range of 6 to 32 megahertz is disclosed in U.S. Patent No. 4,095,168.

At high frequencies, the distributed capacitance of such coils becomes significant so that even a single turn coil becomes "self-resonant". When this limit is approached, the homogeneity of the RF field decreases, due to the phase shift in different parts of the coil. Moreover, as the number of turns of the coil is reduced, the homogeneity as well as efficiency of the coil, both in generating fields and in picking up the signal, is diminished.

A further problem occurring in high frequency superconducting magnets is that the static magnetic field is co-axial with the axis of the cylindrical bore of the magnet. Since the RF field must be perpendicular, i.e., normal, to this axis, the conventional coil design is to place one loop on each side of the cylindrical sample. This inherently inefficient configuration, and variations of it, is the current state of the art in NMR spectrometers.

In the separate but related field of NMR imaging, the sample sizes, frequencies, and magnet geometry are such that exactly the same problems occur. Again, the same general coil designs are the state of the art. In NMR imaging, the homogeneity of the irradiating field and the uniformity of the sensitivity to the signal are even more important than in conventional NMR spectroscopy. Typically, homogeneity can be improved by increasing the diameter of the RF coil and moving it away from the sample. This approach, however, is inherently inefficient and results in decreased magnetic coupling of the coil with the sample.

Typically, the NMR signal improves as the strength of the static magnetic field and the operating frequency are increased. In NMR imaging, the phenomenon which limits the useful operating frequency is the RF absorption effects in the sample. With medical applications, the frequency and coil size at which this limit is approached is such that conventional RF coils suffer from all of the problems discussed above. At any field strength, the efficiency and uniformity of the coupling between the sample and spectrometer have a significant effect on the quality of the resultant image.

Summary of the Present Invention

We have discovered an RF coil arrangement which generally overcomes the problems noted above; principally, by recognizing the phase shift or propagation delay inherent in an RF coil conductor and incorporating this phenomenon into the design in such manner that the delay at each increment of the loop is predetermined and contributes to a high level of magnetic coupling with the sample.

Thus, the propagation delay, inherent in the coil conductor, is incorporated into the design of the coil rather than being treated as a limiting phenomenon. The delays are calculated and used to put the correct current in the correct place. In other words, the electrical phase of the current at each segment of wire which contributes to the magnetic field is in the correct position, due to the geometry of the coil and the distribution of the electrical delays, to produce the desired magnetic field. The result can be considered part RF coil and part resonant transmission line.

In one aspect the invention provides a distributed phase RF coil arrangement for exciting a sample under NMR analysis with an oscillating magnetic field such as an RF field and/or for detecting nuclear magnetic resonance of the sample, and adapted for a relatively high degree of magnetic coupling with the sample, said arrangement comprising:

at least one electrically conductive loop defining an NMR sample region therewithin, said loop having alternating shielded and unshielded segments of predetermined lengths, said shielded segments defining inactive portions of said conductive loop, and

connecting pairs of unshielded segments, said unshielded segments defining active portions of the conductive loop for magnetically coupling with the sample, said unshielded segments being adapted for current propagation along each of said active portions such that the propagation delay between points on said active portions is proportional to the angular displacement along the periphery of the NMR sample region between said points of said active portions.

In a second aspect the invention provides a distributed phase RF coil arrangement for exciting a sample under NMR analysis in a static magnetic field with an oscillating magnetic field such as an RF field and/or for detecting nuclear magnetic resonance of said sample, and adapted for a relatively high level of magnetic coupling with said sample, which comprises:—

a) a coil support defining an NMR sample region therewithin;

b) electrically conductive means for shielding a portion of the NMR sample region from RF irradiation, said shielded portion of the NMR sample region defining therewithin a first inactive portion and thereby delimiting the non-shielded active portion of the sample region;

c) means electrically connected to said shielding means for decoupling a sample within the active portion of the NMR sample region from electric fields of the coil generated by an RF magnetic field and for shielding said sample from axial components of said RF magnetic field and from electrostatic atmospheric noise; and

d) an electrically conductive loop peripherally disposed about said coil support having alternating shielded and unshielded segments for magnetically coupling components of said RF field which are normal to said static field with said sample wherein:

i) said shielded segments define inactive regions of said conductive loop and connect pairs of unshielded segments; and

ii) said unshielded segments define active regions of said conductive loop, said unshielded segments being disposed about the active portion of the NMR sample region in generally axial relation with said coil support being adapted for current propagation along each of said active region segments such that the phase delay between adjacent pairs of active segments of said coil is proportional to the angular displacement between said pair of active segments, thereby generating a magnetic field having a relatively substantial normal component throughout the active portion of said NMR sample region.

In a third aspect the invention provides a distributed phase RF coil arrangement for exciting a sample under NMR analysis in a static magnetic field with an oscillating magnetic field such as an RF field and/or for detecting nuclear magnetic resonance of said sample, and adapted for a relatively high level of magnetic coupling with said sample, which comprises:—

a coil support defining an NMR sample region therewithin; and

an electrically conductive loop comprised of a plurality of active segments and disposed about said coil support for magnetically coupling components of said RF field which are normal to said static field with said sample, said loop, when energized, exhibiting a standing wave.

In a fourth aspect the invention provides a distributed phase RF coil arrangement for exciting a sample under NMR analysis in a static magnetic field with an oscillating magnetic field such as an RF field and/or for detecting nuclear magnetic resonance of said sample, and adapted for a relatively high level of magnetic coupling with said sample, which comprises:

a generally cylindrical coil support defining an NMR sample region therewithin and having a central longitudinal axis; and

an electrically conductive loop disposed about said coil support for magnetically coupling components of said RF field which are normal to said static magnetic field with said sample, said loop including a plurality of active segments for establishing or detecting RF signals, which segments are oriented substantially parallel to said longitudinal axis.

This novel design has the advantages of providing both a uniform irradiating field when used as a transmitting coil and a uniform sensitivity when used as a receiving coil. In imaging applications, this results in a superior image and increased efficiency by permitting the coil to be placed closer to the sample.

This novel design has many more "turns" than the traditional coil for the same frequency and size, a feature made possible by energizing the coil with a standing wave at the frequency of interest. Conventionally, RF coils for NMR apparatus were restricted by wavelength considerations, which dictated that their length be no greater than $\lambda/20$ at the frequency of interest. In the preferred embodiment, the total length of all shielded and unshielded segments is approximately equal to $\lambda$ at the frequency of interest, as adjusted to account for inductive effects between the unshielded segments.

Furthermore, because of the luxury of a substantial coil length, the unshielded segments can be oriented substantially parallel to the axis of the cylindrical coil support. In the preferred embodiment the unshielded segments are interconnected by shielded segments to form the continuous electrically conductive loop. To account for propagation delays, the unshielded segments are slightly angled relative to the axis of the coil support at an angle proportional to their angular displacement along the periphery of the NMR sample region. In the prior art, RF coils were conventionally disposed with unshielded wires wound cylindrically around the coil support, as shown in Fig. 5 of DE—A—2 942 020. However, this document also discloses an NMR RF coil arrangement comprising means for electrostatically decoupling the sample.

In addition to increasing the uniformity as mentioned above, the large number of turns increases the efficiency of the coil. When used as an irradiating coil, this means that the same amount of current produces a higher magnetic field. When used as a receiving coil, this means that the same amount of sample magnetization produces a larger emf.

Preferred embodiments of the invention will now be described, by way of example, with reference to the accompanying drawings, wherein:—

Fig. 1 is a plan view, partly in section, of a coil arrangement according to the present invention.

Fig. 2 is a section taken along line 2—2 of Fig. 1.

Fig. 3 is a development view showing the conductive loop of the coil arrangement of Fig. 1 as it would look if removed from the coil former and laid out flat.

Fig. 4 is a block diagram of a portion of an NMR system including an RF coil arrangement.

Fig. 5 is an example in schematic form of a coupling network.

Fig. 6 is illustrative of a pair of linear transmission lines.

Fig. 7 is a graph of the waveforms of the transmission lines shown in Fig. 6.

Fig. 8 is a diagrammatic representation in perspective of the coil arrangement shown in Fig. 1.

Fig. 9 is an end view of Fig. 8.

Fig. 10 shows an alternate winding of the conductive loop.

Fig. 11 is an end view of Fig. 10.

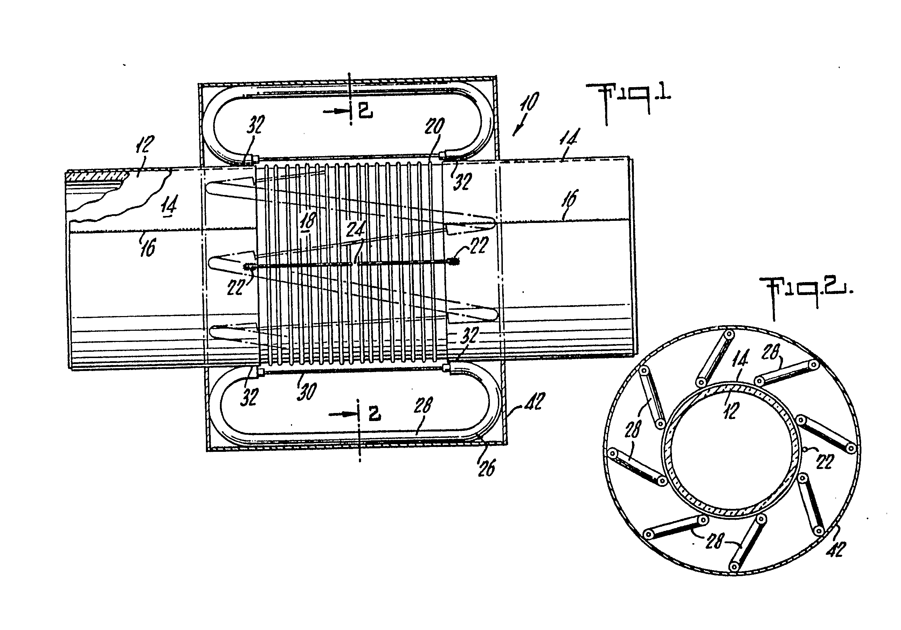

Referring now to Fig. 1, there is shown a distributed phase RF coil arrangement generally designated as 10 incorporating features of the present invention. The RF coil arrangement 10 includes a coil support or coil former 12 which, in one model of the invention, is a 82.55 mm (3-1/4 inch) diameter, 228.6 mm (9 inch) long, insulating tube made of glass and open at both ends. At either end of the glass tube 12 there is provided a 76.20 mm (3 inch) wide strip of thin brass foil 14 which is soldered end to end along line 16 to form a tight fit around the glass tube 12.

The sample that is to undergo analysis is inserted through one end of the glass tube 12, generally in the central region thereof. The two brass foil strips 14 provide an RF shield at each end of the glass tube 12 thereby defining an active portion 18 in the central region of the glass tube 12.

Between the two strips of brass foil 14, a plurality of wires 20 are wound around the glass tube 12. The plurality of wires 20 is preferably copper or other conductive material and soldered by cross wire 22 to form closed loops. The closed loops of wires 20 are spaced at about 3.17 mm (1/8 inch) intervals over the 76.20 mm (3 inch) portion of the glass tube within the two brass foil strips 14. Each end of the cross wire 22 is soldered to one of the brass foil strips 14 and also has a discontinuity 24 therebetween.

The plurality of wires 20 together with cross wire 22 forms a "Faraday shield" for electrostatically decoupling a sample within the active portion 18 of the NMR sample region from electric fields of the coil arrangement 10 and for shielding the coil from electrostatic atmospheric noise. Moreover, the Faraday shield permits the magnetic field to pass through to the sample under NMR analysis. This electric decoupling reduces the RF energy applied to the sample since the energy applied is related to the product of the electric and magnetic fields. The shield also decreases the effect of the sample on the tune of the RF coil arrangement 10. This is crucial since, for example, a slightly conductive sample can increase the distributed capacitance of a coil arrangement and thereby shift its resonant frequency. The Faraday shield together with brass foil strips 14 form a shield between the sample under NMR analysis and the RF coil arrangement 10. This shield does not shield the NMR sample from the desired component of the magnetic field which is the portion normal to the axis of the glass tube 12.

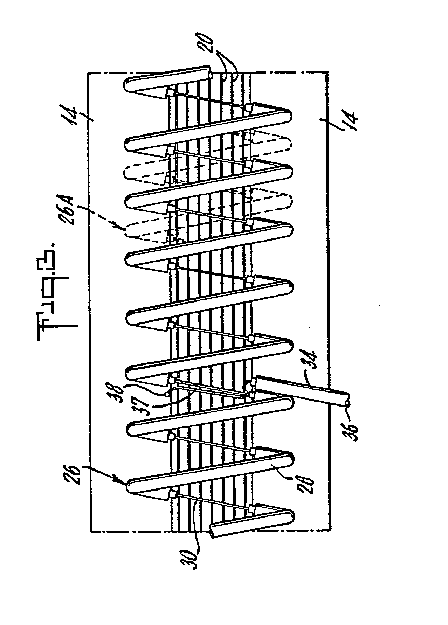

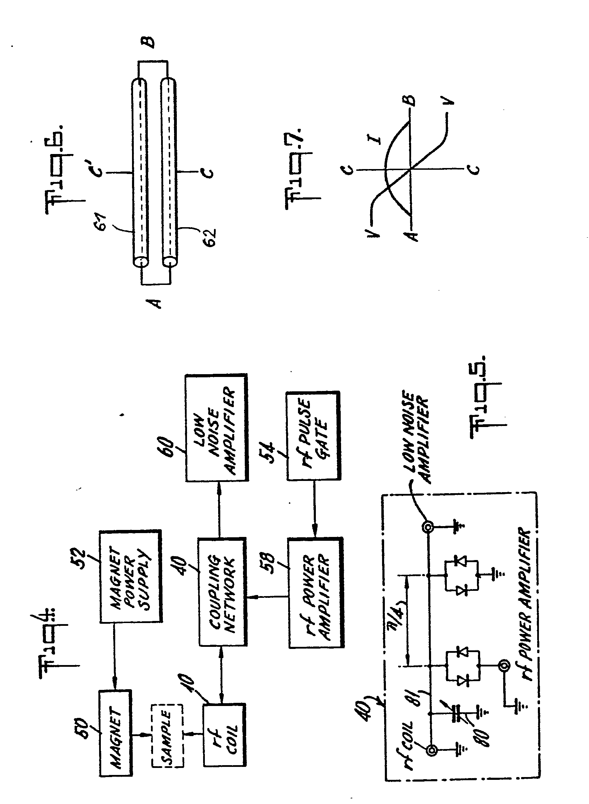

The coil arrangement 10 further includes a closed conductive loop 26 preferably disposed about said glass tube having the general configuration of a toroid. For additional clarity, conductive loop 26 is shown in Fig. 3 as it would look if removed from glass tube 12 and laid out flat. The conductive loop 26 includes shielded coaxial cable segments 28 and unshielded wire segments 30. The unshielded segments 30 comprise the active wires while the shielded coaxial cables 28 form the return or inactive wire portions.

Both ends of the shield of each shielded segment 28 are soldered to brass foil strips 14 at contact points 32. The discontinuity 24 in the cross wire 22 ensures that there is no shorted conducting path parallel to the active wires and between them and the sample. Any such shorted conducting path would tend to reduce the magnetic coupling between the active wires and the sample. In connection with this model of the RF coil arrangement 10, which is approximately 228.6 mm (9 inches) long, the shielded segments of the wire are lifted up and away from the glass tube 12 to a distance approximately 31.75 mm (1-1/4 inches) therefrom. The shielded segments 28 are 4.76 mm (3/16 inch) outer diameter rigid coaxial cable. Each segment of the shielded wire is approximately 152.4 mm (6 inches) long.

The active wire segments 30 are roughly 76.2 mm (3 inches) long and extend across the closed loop wires 20. The resonant frequency of this example is about 60 megahertz. Current propagating along active wires 30 produces a magnetic field in the sample. Similarly, the resonant magnetic field of the sample produces a current in the active wire segments 30. The active wire segments 30 are arranged in generally axial relation with the glass tube 12 to produce lines of flux orthogonal to said axis. Preferably, the active wires 30 are in parallel relation to each other and are slightly angled relative to the axis of tube 12. The combination of the angle of the active wire segments, together with the distance of each of the return wire segments 28, produce the desired effect of overcoming the problem of the phase delay inherent in the distributed capacitance of the conductive loop 26. In other words, the phase delay between adjacent pairs of active segments 30 of the conductive loop 26 is generally equal to the angular displacement between said pair of active segments thereby generating a magnetic field having a relatively substantial normal component throughout the active portion 18 of said NMR sample region.

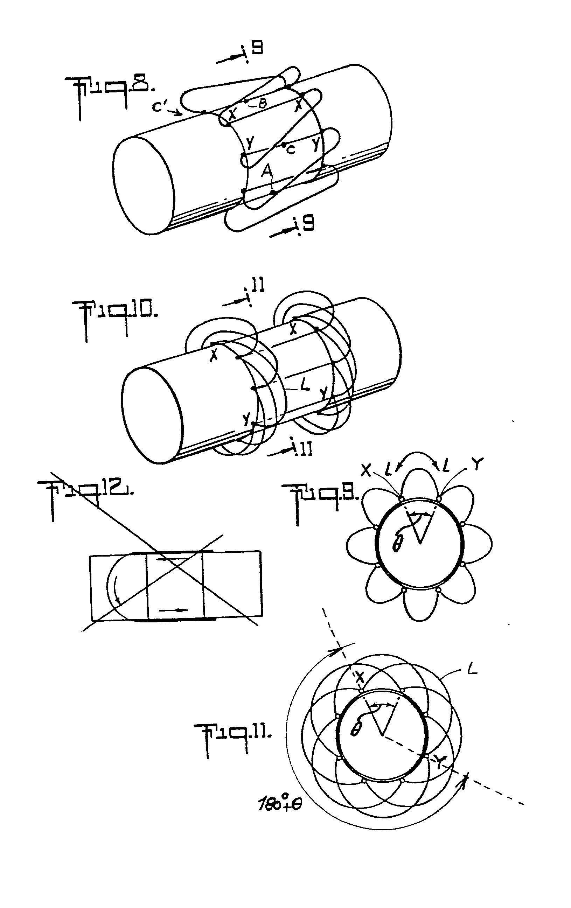

As further shown in Fig. 3, the RF coil arrangement 10 is connected to a spectrometer (not shown) by conductor 34 which is a coaxial cable. The shielded segment 36 of conductor 34 is soldered to the brass foil 14. A portion of the shielding is removed to create active segment 37 of conductor 34 and to permit the active segment 37 to inductively couple to the RF coil arrangement 10. The end of active segment 37 of conductor 34 is soldered to the brass foil 14 at point 38. The active segment 37 is positioned to provide the desired coupling. Preferably, this is accomplished by placing active segment 37 adjacent to one of the active segments 30 of conductive loop 26. The orientation of active segment 37 of conductor 34 affects the coupling achieved so that, together with the conductor 34 and variable capacitor 80 (shown in Fig. 5) the impedance at 81 can be set to 50 ohms to permit impedance matching.

Other modes of coupling to the resonant RF coil arrangement can be made. One example is to couple at two points 90 degrees apart. The nuclear spins of the NMR sample are sensitive only to a rotating magnetic field, or to a circularly polarized magnetic field. By connecting to the RF coil arrangement's conductive loop at two places and driving the two points with a 90 degree phase difference, the field generated is circularly polarized and is, as a result, more effective. The resultant field is twice as strong. Similarly, during the detecting mode, since the NMR magnetization of the sample is circularly polarized, the detection efficiency is thereby improved.

For added shielding, such as for example, from outside noise, an additional thin brass cylindrical shield 42 is wrapped around the outside of return shielded wire segments 28 and is soldered to brass foil strips 14.

The conductive loop 26 described in connection with the preferred embodiment discussed hereinabove, consists of eight active segments 30 and eight return segments 28. Other arrangements are contemplated, however, wherein the number of either active or return segments is some other number. In addition, there may be more than one conductive loop 26. The coupling between the conductive loop 26 and an NMR analysis system as shown in part in Fig. 4 is provided by a conductor 34 which has shielded segment 36 and active segment 37 connected to the RF coil arrangement at connection 38. Adding another conductive loop 26A (a portion of which is shown in Fig. 3) to the RF coil arrangement 10 further increases the uniformity of the RF field and increases the efficiency of the magnetic coupling to the sample by providing more "turns" of the conductive loop. The second conductive loop 26A, essentially identical to conductive loop 26, is assembled about glass tube 12, but offset therefrom by one-half turn spacing. In such a dual conductive loop embodiment, one of the conductive loops can be considered a driven conductive loop while the other one undriven. Coupling between the unshielded or active wires 30 of the driven loop induces current in the undriven loop such that both loops 26 and 26A contribute to the RF field that is coupled to the sample. Conversely, the NMR signal is coupled to both conductive loops 26 and 26A and transmitted to an NMR analysis system.

The RF coil arrangement 10 has a resonant frequency determined by its dimensions and in particular by the total length of the shielded and unshielded wire segments of conductive loop 26. In considering the operation of the conductive loop refer to Fig. 6 which consists of two transmission lines 61 and 62. When driven at point A with a frequency such that the length of a line is $\lambda/2$, the signal in the upper line 61 will meet the signal from the lower line 62 at point B with exactly the same amplitude. Point B will appear as an open circuit for signals on each line. A reflection of the current in each line will occur and will propagate back to point A. The total path travelled by the signal is $\lambda$, i.e., a 360 degree phase shift. The impedance at point A then will also appear nearly as an open circuit and a standing wave will occur on the lines 61 and 62 such that relative voltage maxima occur at points A and B and current maxima at points C and C'. The voltage and current wave forms are graphically presented at Fig. 7.

Now, if this transmission line is wound upon a coil former so that the turns are uniformly distributed and sections of the line are unshielded so as to no longer bound the electromagnetic field between the inner and outer conductors, the configuration of Fig. 8 results, which is seen to be the configuration of Figs. 1—3. Points A and B are on opposite sides of the coil, as are points C and C' as shown in Fig. 8. Thus, it can be seen that as a first approximation, the total length of all segments must approximately equal $\lambda$ at the frequency of interest. The number of turns and the length of the shielded wires can be varied within that limit. Because the field from one unshielded wire is coupled to the adjacent unshielded wires an increase in effective inductance occurs and the frequency of resonance is reduced. The amount of induction is related to the number of turns and the relative lengths of the unshielded wire.

When the transmission line is configured as shown in Fig. 8, the current in each successive segment is shifted by an amount equal to its angular rotation. (See Fig. 9.) Alternatively, if the transmission line is formed as shown in Fig. 10 then the current in segment XX as shown in Fig. 11 is shifted from segment YY by $180° + \theta°$. Similarly, its position on the former is shifted by $180° + \theta°$ as shown in Fig. 11 and the same conditions for a uniform RF field are established as in Fig. 8.

It is possible to couple RF power into the coil by means of coupling loop near an unshielded wire at point C or C'. Coupling is as in a transformer and the high impedance of the coil is lowered by the square root of the turns ratio to values suitable for low impedance transmission lines. Matching can be done either at the coil or at some other point such as the signal separation point 40.

Other configurations of the RF coil arrangement are contemplated when the NMR sample to be imaged would not conveniently fit into a cylindrical shape such as provided within glass tube 12. Examples of such shapes are a sphere for NMR analysis of round shaped objects. Another example would be a cup-shaped configuration which would be advantageous when imaging, for example, a breast.

Referring now to an overview of an NMR system as shown in Fig. 4, the RF coil arrangement 10 is shown as it interrelates with other components of the system. The system includes a magnet 50 which is powered by a magnet power supply 52. There is further included an RF pulse gate 54 for gating radio frequency electrical signals. The radio frequency signals are amplified by a radio frequency power amplifier 58. A coupling network 40 couples the radio frequency excitation signals with the RF coil arrangement 10. Similarly, detection is accomplished by the combination of the RF coil arrangement 10 in its detecting mode, the coupling network 40 and a low noise amplifier 60. The coupling network 40 during detection serves to separate the detected signals from the excitation signals, and the low noise amplifier 60 for amplifying the detected NMR signals. Fig. 5 shows an example of a coupling network 40. Variable capacitor 80 permits adjustment of the RF coil impedance to a value of 50 ohms for proper operation with commercially available RF power amplifier 58 and low noise amplifier 60.

## Claims

1. A distributed phase RF coil arrangement for exciting a sample under NMR analysis with an oscillating magnetic field such as an RF field and/or for detecting nuclear magnetic resonance of the sample, and adapted for a relatively high degree of magnetic coupling with the sample, said arrangement comprising:
at least one electrically conductive loop (26) defining an NMR sample region therewithin, said loop having alternating shielded (28) and unshielded (30) segments of predetermined lengths, said shielded segments defining inactive portions of said conductive loop and connecting pairs of unshielded segments, said unshielded segments defining active portions of the conductive loop for magnetically coupling with the sample, said unshielded segments being adapted for current propagation along each of said active portions such that the propagation delay (X, Y) between points on said active portions is proportional to the angular displacement along the periphery of the NMR sample region between said points of said active portions.

2. A distributed phase RF coil arrangement according to claim 1 further comprising:
a) insulating means (12) for supporting said electrically conductive loop;
b) electrically conductive means (14) for shielding a portion of the NMR sample region from RF irradiation, said shielded portion of the NMR sample region defining therewithin a first inactive portion and thereby delimiting the non-shielded active portion of the sample region; and
c) means (20, 22) electrically connected to said shielding means for electrostatically decoupling a sample within the active portion of the NMR sample region.

3. A distributed phase RF coil arrangement according to claim 2 wherein said decoupling means decouples the NMR sample from electric fields of said conductive loop and said conductive loop from electrostatic atmospheric noise.

4. A distributed phase RF coil arrangement according to any of claims 1 through 3 wherein said shielded segments connect adjacent pairs of unshielded segments.

5. A distributed phase RF coil arrangement according to any of claims 1 through 3 wherein said shielded segments connect diametrically opposed pairs of unshielded segments.

6. A distributed phase RF coil arrangement for exciting a sample under NMR analysis in a static magnetic field with an oscillating magnetic field such as an RF field and/or for detecting nuclear magnetic resonance of said sample, and adapted for a relatively high level of magnetic coupling with said sample, which arrangement comprises:
a) a coil support (12) defining an NMR sample region therewithin;
b) electrically conductive means (14) for shielding a portion of the NMR sample region from RF irradiation, said shielded portion of the NMR sample region defining therewithin a first inactive portion and thereby delimiting the non-shielded active portion of the sample region;
c) means (20, 22) electrically connected to said shielding means for decoupling a sample within the active portion of the NMR sample region from electric fields of the coil generated by an RF magnetic field and for shielding said sample from axial components of said RF magnetic field and from electrostatic atmospheric noise; and
d) an electrically conductive loop (26) peripherally disposed about said coil support having alternating shielded (28) and unshielded segments (30) for magnetically coupling components of said RF field which are normal to said static magnetic field with said sample wherein:
i) said shielded segments define inactive regions of said conductive loop and connect pairs of unshielded segments; and
ii) said unshielded segments define active regions of said conductive loop, said unshielded segments being disposed about the active portion of the NMR sample region in generally axial relation with said coil support being adapted for current propagation along each of said active region segments such that the phase delay between adjacent pairs of active segments of said coil is proportional to the angular displacement between said pair of active segments, thereby generating a magnetic field having a relatively substantial normal component throughout the active portion of said NMR sample region.

7. A distributed phase RF coil arrangement according to claim 6 wherein said coil support is a cylindrically shaped insulator.

8. A distributed phase RF coil arrangement according to claim 6 or 7 wherein said decoupling means comprises a plurality of wires wound about said coil support about the active portion of the NMR sample region.

9. A distributed phase RF coil arrangement according to claim 6, 7 or 8 which further comprises a second electrically conductive loop peripherally disposed about said coil support having alternating shielded and unshielded segments for magnetically coupling normal components of said RF field with said sample.

10. A distributed phase RF coil arrangement according to any of claims 6 to 9 wherein the normal component of said magnetic field is generally uniform through said NMR sample region.

11. A distributed phase RF coil arrangement for exciting a sample under NMR analysis in a static magnetic field with an oscillating magnetic field such as an RF field and/or for detecting nuclear magnetic resonance of said sample, and adapted for a relatively high level of magnetic coupling with said sample, which arrangement comprises:

a coil support (12) defining an NMR sample region therewithin; and

an electrically conductive loop (26) comprised of a plurality of active segments and disposed about said coil support for magnetically coupling components of said RF field which are normal to said static magnetic field with said sample, said loop, when energized, exhibiting a standing wave.

12. A distributed phase RF coil arrangement according to claim 11, wherein said loop, when energized, exhibits at least two points of relative maximum current.

13. A distributed phase RF coil arrangement according to claim 11, wherein said loop has a total length of approximately an integer multiple of one wavelength ($\lambda$) at an RF frequency of interest.

14. A distributed phase RF coil arrangement according to claim 13, wherein said length of said loop varies from that of an integer multiple of one wavelength in compensation for inductance effects.

15. A distributed phase RF coil arrangement for exciting a sample under NMR analysis in a static magnetic field with an oscillating magnetic field such as an RF field and/or for detecting nuclear magnetic resonance of said sample, and adapted for a relatively high level of magnetic coupling with said sample, which arrangement comprises:

a generally cylindrical coil support (12) defining an NMR sample region therewithin and having a central longitudinal axis; and

an electrically conductive loop (26) disposed about said coil support for magnetically coupling components of said RF field which are normal to said static magnetic field with said sample, said loop including a plurality of active segments for establishing or detecting RF signals, which active segments are oriented substantially parallel to said longitudinal axis.

16. A distributed phase RF coil arrangement according to claim 15, wherein said loop further includes a plurality of shielded conductive segments (28) for interconnecting said active segments which establish or detect RF signals.

17. A distributed phase RF coil arrangement according to claim 15, further including means for energizing said loop to produce a rotating magnetic field within said NMR sample region.

18. A distributed phase RF coil arrangement according to claim 15, further including means for energizing said loop to produce a circularly polarized magnetic field within said NMR region.

19. A distributed phase RF coil arrangement according to claim 18, wherein said circularly polarized magnetic field energizing means comprises means for coupling RF signals to said loop at points about said longitudinal axis which are ninety degrees apart.

20. A distributed phase RF coil arrangement according to claim 19, wherein said RF signal coupling means couples signals to said loop at said points which exhibit a ninety degree phase difference at a frequency of interest.

21. A distributed phase RF coil arrangement according to claim 15, wherein said loop is energized to produce a standing wave.

22. A distributed phase RF coil arrangement according to claim 21, wherein the phases of current in said segments relative to a reference point on said loop substantially corresponds to the angular positions at which respective ones of said segments are disposed about said coil support relative to said reference point.

23. A distributed phase RF coil arrangement according to claim 15, wherein the maximum current appearing in ones of said segment substantially corresponds to the angular positions at which respective ones of said segments are disposed about said coil support.

24. A distributed phase RF coil arrangement according to claim 21, wherein said energization produces an oscillating magnetic field orthogonal to said axis at an RF frequency of interest within said NMR sample region.

25. A distributed phase RF coil arrangement according to claim 15, wherein said active segments are oriented parallel to each other and slightly angled from an exact parallel relationship relative to said longitudinal axis.

**Patentansprüche**

1. Phasenverteilende RF-Spulenanordnung für die Erregung einer Probe bei der NMR-Analyse mit einem oszillierenden Magnetfeld, wie einem RF-Feld und/oder zum Ermitteln magnetischer Kernresonanz der Probe, und die für eine relativ starke magnetische Kopplung mit der Probe eingerichtet ist, die Anordnung enthaltend:

wenigstens eine elektrisch leitfähige Schleife (26), die einen NMR-Probenbereich darin definiert, wobei die Schleife alternierende abgeschirmte (28) und unabgeschirmte (30) Segmente vorbestimmter Längen hat, die abgeschirmten Segmente die inaktiven Abschnitte der leitfähigen Schleife definieren und Paare unabgeschirmter Segmente verbinden, die unabgeschirmten Segmente die aktiven Abschnitte der leitfähigen Schleife für die magnetische Kopplung mit der Probe definieren, die unabgeschirmten Segmente für die Stromfortleitung längs jedem der aktiven Abschnitte eingerichtet sind, derart, daß die Fortleitungsverzögerung (X, Y) zwischen Punkten auf den aktiven Abschnitten proportional der Winkelverschiebung längs des Umfangs des NMR-Probenbereiches zwischen den genannten Punkten der aktiven Abschnitte ist.

2. Phasenverteilende RF-Spulenanordnung nach Anspruch 1, weiterhin enthaltend:

a) Isoliereinrichtungen (12) zum Abstützen der elektrisch leitfähigen Schleife;

(b) elektrisch leitfähige Einrichtungen (14) zum Abschirmen eines Teils des NMR-Probenbereichs von der RF-Bestrahlung, wobei der abgeschirmte Teil des NMR-Probenbereiches darin einen ersten inaktiven Abschnitt definiert und dadurch den nicht abgeschirmten aktiven Teil des Probenbereiches begrenzt; und

(c) Einrichtungen (20, 22), die elektrisch mit den Abschirmeinrichtungen verbunden sind, um eine Probe in dem aktiven Teil des NMR-Probenbereiches elektrostatisch zu entkoppeln.

3. Phasenverteilende RF-Spulenanordnung nach Anspruch 2, bei der die Entkopplungseinrichtung die NMR-Probe von elektrischen Feldern der leitfähigen Schleife und die leitfähige Schleife von elektrostatischen atmosphärischen Störungen entkoppelt.

4. Phasenverteilende RF-Spulenanordnung nach einem der Ansprüche 1 bis 3, bei der die abgeschirmten Segmente benachbarte Paare unabgeschirmter Segmente verbinden.

5. Phasenverteilende RF-Spulenanordnung nach einem der Ansprüche 1 bis 3, bei der die abgeschirmten Segmente diametral gegenüberstehende Paare unabgeschirmter Segmente verbinden.

6. Phasenverteilende RF-Spulenanordnung zum Erregen einer Probe bei der NMR-Analyse in einem statischen Magnetfeld mit einem oszillierenden Magnetfeld, wie einem RF-Feld und/oder zum Ermitteln magnetischer Kernresonanz der Probe, und für eine relativ starke magnetische Kopplung mit der Probe eingerichtet, welche Anordnung enthält:

(a) einen Spulenträger (12), der darin einen NMR-Probenbereich definiert;

(b) elektrisch leitfähige Einrichtungen (14) zum Abschirmen eines Teils des NMR-Probenbereiches gegen RF-Bestrahlung, wobei der abgeschirmte Teil des NMR-Probenbereiches darin einen ersten inaktiven Abschnitt definiert und dadurch den nicht abgeschirmten aktiven Teil des Probenbereiches begrenzt;

(c) Einrichtungen (20, 22), die elektrisch mit den Abschirmeinrichtungen verbunden sind, um eine Probe innerhalb des aktiven Teils des NMR-Probenbereiches von elektrischen Feldern der Spule abzuschirmen, die durch ein RF-Magnetfeld erzeugt werden und um die Probe gegenüber Axialkomponenten des RF-Magnetfeldes und von elektrostatischen atmosphärischen Störungen abzuschirmen; und

(d) eine elektrisch leitfähige Schleife (26), die umfangsmäßig um den Spulenhalter angeordnet ist und alternierend abgeschirmte (28) und unabgeschirmte Segmente (30) enthält, um magnetisch Komponenten des RF-Feldes, die senkrecht zu dem statischen Magnetfeld sind, mit der Probe zu koppeln, worin:

(i) die abgeschirmten Segmente inaktive Bereiche der leitfähigen Schleife definieren und Paare unabgeschirmter Segmente verbinden; und

(ii) die unabgeschirmten Segmente aktive Bereiche der leitfähigen Schleife definieren, wobei die unabgeschirmten Segmente um den aktiven Teil des NMR-Abtastbereiches in im allgemeinen axialer Beziehung mit dem Spulenhalter angeordnet sind und für die Stromfortleitung längs jedes der aktiven Bereichssegmente eingerichtet sind, derart, daß die Phasenverzögerung zwischen benachbarten Paaren aktiver Segmente der Spule proportional der Winkelverschiebung zwischen dem genannten Paar aktiver Segmente ist, um dadurch ein Magnetfeld zu erzeugen, das eine relativ wesentliche senkrechte Komponente durch den aktiven Teil des NMR-Probenbereiches hat.

7. Phasenverteilende RF-Spulenanordnung nach Anspruch 6, bei der der Spulenhalter ein zylindrisch gestalteter Isolator ist.

8. Phasenverteilende RF-Spulenanordnung nach Anspruch 6 oder 7, bei der die Entkopplungseinrichtung eine Mehrzahl von Drähten aufweist, die um den Spulenhalter um den aktiven Teil des NMR-Probenbereiches gewunden sind.

9. Phasenverteilende RF-Spulenanordnung nach Anspruch 6, 7 oder 8, die weiterhin eine elektrisch leitfähige Schleife enthält, die peripher um den Spulenhalter angeordnet ist und alternierend abgeschirmte und unabgeschirmte Segmente für die magnetische Kopplung senkrechter Komponenten des genannten RF-Feldes mit der Probe hat.

10. Phasenverteilende RF-Spulenanordnung nach einem der Ansprüche 6 bis 9, bei der die senkrechte Komponente des Magnetfeldes im allgemeinen gleichmäßig durch den NMR-Probenbereich ist.

11. Phasenverteilende RF-Spulenanordnung zum Erregen einer Probe bei der NMR-Analyse in einem statischen Magnetfeld mit einem oszillierenden Magnetfeld, wie einem RF-Feld und/oder zum Ermitteln der magnetischen Kernresonanz der Probe und eingerichtet für eine relativ starke magnetische Kopplung mit der Probe, welche Anordnung enthält:

einen Spulenhalter (12), der einen NMR-Probenbereich drin definiert; und

eine elektrisch leitfähige Schleife (26), die aus einer Mehrzahl von aktiven Segmenten besteht und um den Spulenhalter für die magnetische Kopplung von Komponenten des RF-Feldes mit der Probe, die senkrecht zu dem statischen Magnetfeld sind, angeordnet ist, wobei die Schleife, wenn sie erregt ist, eine stehende Welle erzeugt.

12. Phasenverteilende RF-Spulenanordnung nach Anspruch 11, bei der die Schleife, wenn sie erregt ist, wenigstens an zwei Punkten einen relativen Maximalstrom zeigt.

13. Phasenverteilende RF-Spulenanordnung nach Anspruch 11, bei der die Schleife eine Gesamtlänge von ungefähr einem ganzen Vielfachen einer Wellenlänge ($\lambda$) bei der interessierenden RF-Frequenz hat.

14. Phasenverteilende RF-Spulenanordnung nach Anspruch 13, bei der die genannte Länge der Schleife von der des ganzzahligen Vielfachen einer Wellenlänge zur Kompensation von Induktanzeffekten variiert.

15. Phasenverteilende RF-Spulenanordnung zum Erregen einer Probe bei der NMR-Analyse in einem statischen Magnetfeld mit einem oszillierenden Magnetfeld, einem RF-Feld, und/oder zum Ermitteln magnetischer Kernresonanz der Probe und für eine relativ starke magnetische Kopplung mit der Probe eingerichtet, welche Anordnung enthält:

einen im wesentlichen zylindrischen Spulenhalter (12), der darin einen NMR-Probenbereich definiert und eine zentrale Längsachse hat; und

eine elektrisch leitfähige Schleife (26), die um den Spulenhalter angeordnet ist zum magnetischen Koppeln von Komponenten des RF-Feldes mit der Probe, die senkrecht zu dem statischen Magnetfeld steht, wobei die Schleife eine Mehrzahl von aktiven Segmenten zum Erzeugen oder Ermitteln von RF-Signalen aufweist, welche aktive Segmente im wesentlichen parallel zur genannten Längsachse orientiert sind.

16. Phasenverteilende RF-Spulenanordnung nach Anspruch 15, bei der die Schleife weiterhin eine Mehrzahl von abgeschirmten leitfähigen Segmenten (28) zum gegenseitigen Verbinden der aktiven Segmente enthält, die die RF-Signale erzeugen oder ermitteln.

17. Phasenverteilende RF-Spulenanordnung nach Anspruch 15, weiterhin enthaltend Einrichtungen zum Erregen der Schleife, um ein rotierendes Magnetfeld innerhalb des NMR-Probenbereiches zu erzeugen.

18. Phasenverteilende RF-Spulenanordnung nach Anspruch 15, weiterhin enthaltend Einrichtungen zum Erregen der Schleife, um ein zirkular polarisiertes Magnetfeld innerhalb des NMR-Probenbereiches zu erzeugen.

19. Phasenverteilende RF-Spulenanordnung nach Anspruch 18, bei der die das zirkular polarisierte Magnetfeld erregenden Einrichtungen eine Einrichtung zum Koppeln von RF-Signalen auf die Schleife an Punkten um die genannte Längsachse, die um 90° gegeneinander versetzt sind, enthält.

20. Phasenverteilende RF-Spulenanordnung nach Anspruch 19, bei der die RF-Signale koppelnde Einrichtung Signale auf die Schleife an Punkten koppelt, die eine 90°-Phasendifferenz bei einer interessierenden Frequenz zeigen.

21. Phasenverteilende RF-Spulenanordnung nach Anspruch 15, bei der die Schleife zur Erzeugung einer stehende Welle erregt wird.

22. Phasenverteilende RF-Spulenanordnung nach Anspruch 21, bei der die Phasen von Strömen in den genannten Segmenten in Bezug auf einen Bezugspunkt auf der Schleife im wesentlichen den Winkelpositionen entsprechen, unter welchen entsprechende Segmente um den Spulenhalter relativ zu dem genannten Bezugspunkt angeordnet sind.

23. Phasenverteilende RF-Spulenanordnung nach Anspruch 15, bei der ein Maximalstrom in solchen der Segmente erscheint, die im wesentlichen den Winkelpositionen entsprechen, bei welchem die entsprechenden Segmente um den Spulenhalter angeordnet sind.

24. Phasenverteilende RF-Spulenanordnung nach Anspruch 21, bei der die Erregung ein oszillierendes Magnetfeld orthogonal zu der Achse mit einer in Betracht kommenden RF-Frequenz innerhalb des NMR-Probenbereiches erzeugt.

25. Phasenverteilende RF-Spulenanordnung nach Anspruch 15, bei der aktiven Segmente parallel zueinander und leicht abgewinkelt aus einem exakt parallelen Verhältnis relativ zur genannten Längsachse ausgerichtet sind.

**Revendications**

1. Dispositif de bobine à radiofréquence à distribution de phase pour exciter un échantillon qui subit une analyse par résonance magnétique nucléaire au moyen d'un champ magnétique oscillant tel qu'un champ de radiofréquence et/ou pour détecter une résonance magnétique nucléaire de l'échantillon, et prévu pour donner un degré relativement élevé de couplage magnétique avec l'échantillon, ledit dispositif comportant:

au moins une boucle électriquement conductrice (26) définissant en son intérieur une région pour l'échantillon qui subit une analyse par résonance magnétique nucléaire, ladite boucle comprenant alternativement des segments blindés (29) et des segments non blindés (30) de longueur prédéterminée, lesdits segments blindés définissant des portions inactives de ladite boucle conductrice et reliant des paires de segments non blindés, lesdits segments non blindés définissant des portions actives de la boucle conductrice pour réaliser un accouplement magnétique avec l'échantillon, lesdits segments non blindés étant adaptés pour que la propagation du courant le long de chacune desdites portions actives se fasse de façon telle que le retard de propagation (X, Y) entre des points situés sur lesdites portions actives soit proportionnel au déplacement angulaire, le long de la périphérie de la région pour l'échantillon qui subit une analyse par résonance magnétique, entre lesdits points desdites portions actives.

2. Dispositif de bobine à radiofréquence à distribution de phase selon la revendication 1, comportant en outre:

a) des moyens isolants (12) pour supporter ladite boucle électriquement conductrice;

b) des moyens électriquement conducteurs (14) pour protéger par blindage une portion de la région pour l'échantillon qui subit une analyse par résonance magnétique nucléaire à l'égard des radiations de radiofréquence, ladite portion protégée par blindage de la région pour l'échantillon qui subit une analyse par résonance magnétique nucléaire définissant en son intérieur une première portion inactive et délimitant ainsi la portion active non protégée par blindage de la région pour l'échantillon; et

c) des moyens (20, 22) reliés électriquement audit moyen de protection par blindage pour désaccoupler électrostatiquement un échantillon qui se trouve dans la portion active de la région pour l'échantillon qui subit une analyse par résonance magnétique nucléaire.

3. Dispositif de bobine à radiofréquence à distribution de phase selon la revendication 2, dans lequel lesdits moyens de désaccouplement désaccouplent l'échantillon qui subit une analyse par résonance magnétique nucléaire d'avec les champs électriques de ladite boucle conductrice et ladite boucle conductrice d'avec les bruits atmosphériques électrostatiques.

4. Dispositif de bobine à radiofréquence à distribution de phase selon l'une quelconque des revendications 1 à 3, dans lequel lesdits segments blindés relient des paires adjacentes de segments non blindés.

5. Dispositif de bobine à radiofréquence à distribution de phase selon l'une quelconque des revendications 1 à 3, dans lequel lesdits segments blindés relient des paires diamétralement opposées de segments non blindés.

6. Dispositif de bobine à radiofréquence à distribution de phase pour exciter un échantillon qui se trouve dans un champ magnétique statique et subit une analyse par résonance magnétique nucléaire, en présence d'un champ magnétique oscillant tel qu'un champ de radiofréquence et/ou pour détecter une résonance magnétique nucléaire dudit échantillon et prévu pour un niveau relativement élevé d'accouplement magnétique avec ledit échantillon, dispositif qui comporte:

a) une bobine support (12) définissant en son intérieur une région pour l'échantillon qui subit une analyse par résonance magnétique nucléaire;

b) des moyens électriquement conducteurs (14) pour protéger par blindage une portion de la région pour l'échantillon qui subit une analyse par résonance magnétique nucléaire à l'égard des radiations de radiofréquence, ladite portion protégée par blindage de la région pour l'échantillon qui subit une analyse par résonance magnétique nucléaire définissant en son intérieur une première portion inactive et délimitant ainsi la portion active non protégée par blindage de la région pour l'échantillon;

c) des moyens (20, 22) électriquement reliés auxdits moyens de protection par blindage pour désaccoupler un échantillon qui se trouve dans la portion active de la région pour échantillon qui subit une analyse par résonance magnétique nucléaire d'avec les champs électriques de la bobine générés par un champ magnétique à radiofréquence et pour protéger par blindage ledit échantillon à l'égard des composantes axiales dudit champ magnétique à radiofréquence et à l'égard des bruits atmosphériques électrostatiques; et

d) une boucle électriquement conductrice (26) disposée sur la périphérie et autour dudit support de bobine qui présente alternativement des segments blindés (28) et des segments non blindés (30) pour accoupler magnétiquement les composantes dudit champ à radiofréquence qui sont normales audit champ magnétique statique avec ledit échantillon, dans laquelle:

i) lesdits segments blindés définissent des régions inactives de ladite boucle conductrice et relient des paires de segments non blindés; et

ii) lesdits segments non blindés définissent des région actives de ladite boucle conductrice, lesdits segments non blindés étant disposés autour de la portion active de la région pour l'échantillon qui subit l'analyse par résonance magnétique nucléaire, et de façon générale selon l'axe, ledit support de bobine étant prévu pour que la propagation du courant le long de chacun desdits segments de la région active soit telle que le retard de phase entre des paires voisines de segments actifs de ladite bobine soit proportionnel au déplacement angulaire entre lesdites paires de segments actifs, générant ainsi une champ magnétique qui présente une composante relativement sensiblement normale sur toute la portion active de ladite région pour échantillon qui subit une analyse par résonance magnétique nucléaire.

7. Dispositif de bobine à radiofréquence à distribution de phase selon la revendication 6, dans lequel ledit support de bobine est un isolateur de forme cylindrique.

8. Dispositif de bobine à radiofréquence à distribution de phase selon la revendication 6 ou la revendication 7 dans lequel lesdits moyens de désaccouplement comportent un certain nombre de fils métalliques bobinés autour dudit support de bobine, autour de la portion active de la région pour l'échantillon qui subit une analyse par résonance magnétique nucléaire.

9. Dispositif de bobine à radiofréquence à distribution de phase selon la revendication 6, 7 ou 8, comportant en outre une seconde boucle électriquement conductrice disposée sur la périphérie et autour dudit support de bobine et présentant alternativement des segments blindés et des segments non blindés pour réaliser un accouplement magnétique des composantes normales dudit champ à radiofréquence avec ledit échantillon.

10. Dispositif de bobine à radiofréquence à distribution de phase selon l'une quelconque des revendications 6 à 9, dans lequel la composante normale dudit champ magnétique est, de façon générale, uniforme dans toute ladite région pour l'échantillon qui subit une analyse par résonance magnétique nucléaire.

11. Dispositif de bobine à radiofréquence à distribution de phase pour exciter un échantillon qui se trouve dans un champ magnétique statique et subit une analyse par résonance magnétique nucléaire en présence d'un champ magnétique oscillant tel qu'un champ de radiofréquence et/ou pour détecter une résonance magnétique nucléaire dudit échantillon et prévu pour un niveau relativement élevé d'accouplement magnétique avec ledit échantillon, dispositif qui comporte:

une bobine support (12) définissant en son intérieur une région pour l'échantillon qui subit une analyse par résonance magnétique nucléaire; et une boucle électriquement conductrice (26) comprenant un certain nombre de segments actifs et disposée autour dudit support de bobine pour réaliser l'accouplement magnétique des composantes dudit champ à radiofréquence qui sont normales audit champ magnétique statique avec ledit échantillon, ladite boucle, lorsqu'on y fait passer un courant, donnant une onde stationnaire.

12. Dispositif de bobine à radiofréquence à distribution de phase selon la revendication 11, dans lequel ladite boucle, lorsqu'on y fait passer un courant, donne au moins deux points d'intensité relative maximale.

13. Dispositif de bobine à radiofréquence à distribution de phase selon la revendication 11, dans lequel ladite boucle a une longueur totale qui est environ un multiple entier d'une longueur d'onde (λ) d'une fréquence intéressante choisie dans le domaine de la radiofréquence.

14. Dispositif de bobine à radiofréquence à distribution de phase selon la revendication 13, dans lequel ladite longueur de ladite boucle s'écarte de celle d'un multiple entier d'une longueur d'onde pour compenser les effets de l'inductance.

15. Dispositif de bobine à radiofréquence à distribution de phase pour exciter un échantillon qui se trouve dans un champ magnétique statique et subit une analyse par résonance magnétique nucléaire, en présence d'un champ magnétique oscillant tel qu'un champ de radiofréquence et/ou pour détecter une résonance magnétique nucléaire dudit échantillon et prévu pour un niveau relativement élevé d'accouplement magnétique avec ledit échantillon, dispositif qui comporte:

un support de bobine de forme générale cylindrique (12) définissant en son intérieur une région pour l'échantillon qui subit une analyse par résonance magnétique nucléaire et présentant un axe longitudinal central; et

une boucle électriquement conductrice (26) disposée autour dudit support de bobine pour réaliser l'accouplement magnétique des composantes dudit champ de radiofréquence qui sont normales audit champ magnétique statique avec ledit échantillon, ladite boucle incluant un certain nombre de segments actifs pour établir ou détecter des signaux de radiofréquence, ces segments actifs étant orientés sensiblement parallèlement audit axe longitudinal.

16. Dispositif de bobine à radiofréquence à distribution de phase selon la revendication 15, dans lequel ladite boucle comporte en outre un certain nombre de segments conducteurs blindés (28) pour interconnecter lesdits segments actifs qui établissent ou détectent des signaux de radiofréquence.

17. Dispositif de bobine à radiofréquence à distribution de phase selon la revendication 15, comportant en outre des moyens pour faire passer un courant dans ladite boucle pour produire un champ magnétique tournant à l'intérieur de ladite région pour l'échantillon qui subit une analyse par résonance magnétique nucléaire.

18. Dispositif de bobine à radiofréquence à distribution de phase selon la revendication 15, comportant en outre des moyens pour faire passer un courant dans ladite boucle pour produire un champ magnétique polarisé circulairement à l'intérieur de ladite région pour l'échantillon qui subit une analyse par résonance magnétique nucléaire.

19. Dispositif de bobine à radiofréquence à distribution de phase selon la revendication 18, dans lequel lesdits moyens de production d'un champ magnétique polarisé circulairement comportent des moyens pour réaliser l'accouplement de signaux de radiofréquence sur ladite boucle en des points situés autour dudit axe longitudinal et écartés l'un de l'autre de quatre-vingt-dix degrés.

20. Dispositif de bobine à radiofréquence à distribution de phase selon la revendication 19, dans lequel lesdits moyens de réaliser l'accouplement des signaux de radiofréquence réalisent cet accouplement sur ladite boucle auxdits points qui montrent une différence de phase de quatre-vingt-dix degrés à une fréquence intéressante.

21. Dispositif de bobine à radiofréquence à distribution de phase selon la revendication 15, dans lequel on fait passer un courant dans ladite boucle pour produire une onde stationnaire.

22. Dispositif de bobine à radiofréquence à distribution de phase selon la revendication 21, dans lequel les phases des courants qui passent dans lesdits segments par rapport à un point de référence sur ladite boucle correspondent sensiblement aux positions angulaires selon lesquelles ceux, mentionnés, desdits segments sont disposés autour dudit support de bobine par rapport audit point de référence.

23. Dispositif de bobine à radiofréquence à distribution de phase selon la revendication 15, dans lequel l'intensité maximale apparaissant dans certains desdits segments correspond sensiblement aux positions angulaires selon lesquelles ceux mentionnés desdits segments sont disposés autour dudit support de bobine.

24. Dispositif de bobine à radiofréquence à distribution de phase selon la revendication 21, dans lequel ledit passage de courant produit un champ magnétique oscillant orthogonal audit axe à une radiofréquence intéressante à l'intérieur de ladite région pour l'échantillon qui subit une analyse par résonance magnétique nucléaire.

25. Dispositif de bobine à radiofréquence à distribution de phase selon la revendication 15, dans lequel lesdits segments actifs sont orientés parallèlement l'un à l'autre en formant un angle faible par rapport à la position exactement parallèle audit axe longitudinal.

Fig.1

Fig.2

0 047 065

Fig. 2.

Fig.6.

Fig.7.

Fig.4.

Fig.5.

MAGNET POWER SUPPLY 52

MAGNET 50

SAMPLE

rf COIL 10

COUPLING NETWORK 40

LOW NOISE AMPLIFIER 60

rf POWER AMPLIFIER 58

rf PULSE GATE 54

LOW NOISE AMPLIFIER

rf COIL 81

λ/4

80

40

rf POWER AMPLIFIER

61

62

A

B

C'

C

A

B

C

C

I

V

V

0 047 065

4